Europäisches Patentamt

European Patent Office

Office européen des brevets

(11) Publication number: **0 129 356**
**A2**

## (12) EUROPEAN PATENT APPLICATION

(21) Application number: **84303689.8**

(22) Date of filing: **01.06.84**

(51) Int. Cl.³: **G 01 N 24/08**

(30) Priority: **20.06.83 GB 8316759**

(43) Date of publication of application:
**27.12.84 Bulletin 84/52**

(84) Designated Contracting States:
**DE FR NL**

(71) Applicant: **PICKER INTERNATIONAL LIMITED**
**East Lane**
**Wembley Middlesex HA9 7PR(GB)**

(72) Inventor: **Bailes, David Robert**
**17A Grosvenor Road**
**Hanwell London W7 1HP(GB)**

(74) Representative: **Pope, Michael Bertram Wingate**
**Central Patent Department The General Electric**
**Company, p.l.c. Hirst Research Centre East Lane**
**Wembley Middlesex HA9 7PP(GB)**

(54) Nuclear magnetic resonance method and apparatus.

(57) A NMR imaging method and apparatus effective to cause spins of a chosen nucleus within a body to rotate through an angle of 180° wherein degradation of the image due to non-uniformity of the r.f. coil (9) is reduced. The method includes applying an even number of r.f. magnetic field pulses ($B_2$, $B_4$) at the Larmor frequency for a chosen nucleus in the body and each intended to rotate the spins of these nuclei through 180°, half of the number of pulses having a phase difference of 180° with respect to the other half of the number of pulses. NMR signals from the body are measured after each pulse, and the signals are averaged.

Fig. 3.

EP 0 129 356 A2

-1-

PKR/2243/EPC

## Nuclear Magnetic Resonance Method and apparatus.

This invention relates to methods and apparatus for investigating the spatial distribution of a quantity relating to nuclear magnetic resonance (NMR) in a body.

NMR techniques have been used for the chemical analysis of material for many years. More recently NMR techniques have been used to obtain images representing the distribution over a selected cross-sectional slice or volume of a body of a chosen quantity, e.g. the density of chosen nuclei, for example hydrogen protons, or of NMR spin relaxation time constants. Such distributions are similar to, although of differemt significance from, the distributions of X-ray attenuation provided by computerised tomography systems. In such methods, for example in methods employing a spin-echo sequence, it is often necessary to apply an r.f. pulse sufficient to rotate the magnetic vectors i.e. spins, of a chosen nuclei within the body through an angle of $180^{\circ}$ from their previous axes of magnetic alignment. Because of the non-uniformity of the r.f. coil which supplies these pulses, however, it is often found that spins at points within the body are rotated through angles other than the intended $180^{\circ}$, this causing degradation of the image produced. Furthermore in sequences, for example multislice sequences, where it is required to rotate the spins only within a selected slice of the body by $180^{\circ}$, spins within the regions immediately outside the selected slice will be rotated by lesser angles, this also causing degradation of the image produced.

It is an object of the present invention to provide a method of applying a sequence of pulses including pulses effective to rotate spins of a chosen nuclei within the body or within a selected slice of the body, through an angle of 180° from their previous axes of magnetic alignment wherein this degradation of the image is reduced.

According to the present invention a method of investigating the spatial distribution of a quantity relating to nuclear magnetic resonance in a body includes: applying an even number of r.f. magnetic field pulses each at the Larmor frequency for a chosen nucleus in the body and each intended to rotate the spins of said nuclei through substantially 180°, half of said number of pulses having a phase difference of substantially 180° with respect to the other half of said number of pulses; measuring nuclear magnetic resonance signals from said body after each of said pulses; and averaging said signals.

The invention also provides an apparatus for investigating the spatial distribution of a quantity relating to nuclear magnetic resonance in a body including: means arranged to apply an even number of r.f. magnetic field pulses each at the Larmor frequency for a chosen nucleus in the body and each intended to rotate the spins of said nuclei through substantially 180°, half of said number of pulses having a phase difference of substantially 180° with respect to the other half of said number of pulses; means arranged to measure nuclear magnetic resonance signals from said body after each of said pulses; and means arranged to average said signals.

One method in accordance with the invention together with apparatus arranged to carry out this method will now be described, by way of example only, with reference to the accompanying drawings in which:

Figures 1 and 2 illustrate the apparatus diagrammatically; and

Figure 3 illustrates the magnetic field pulse sequence employed in the method.

The method is performed using an apparatus similar to that described in U.K. Patent Specification No. 1578910 or No. 2056078, to which reference should be made for a fuller description, appropriately programmed to apply a sequence of magnetic field gradient and r.f. pulses and analyse the resulting signals as hereafter described.

The essential features of such an apparatus in so far as is required for an understanding of the present invention are as follows:

The apparatus includes a first coil system whereby a magnetic field can be applied to a body to be examined in a given direction, normally designated the Z-direction, with a gradient in any one or more of the three orthogonal directions i.e. X, Y and Z directions.

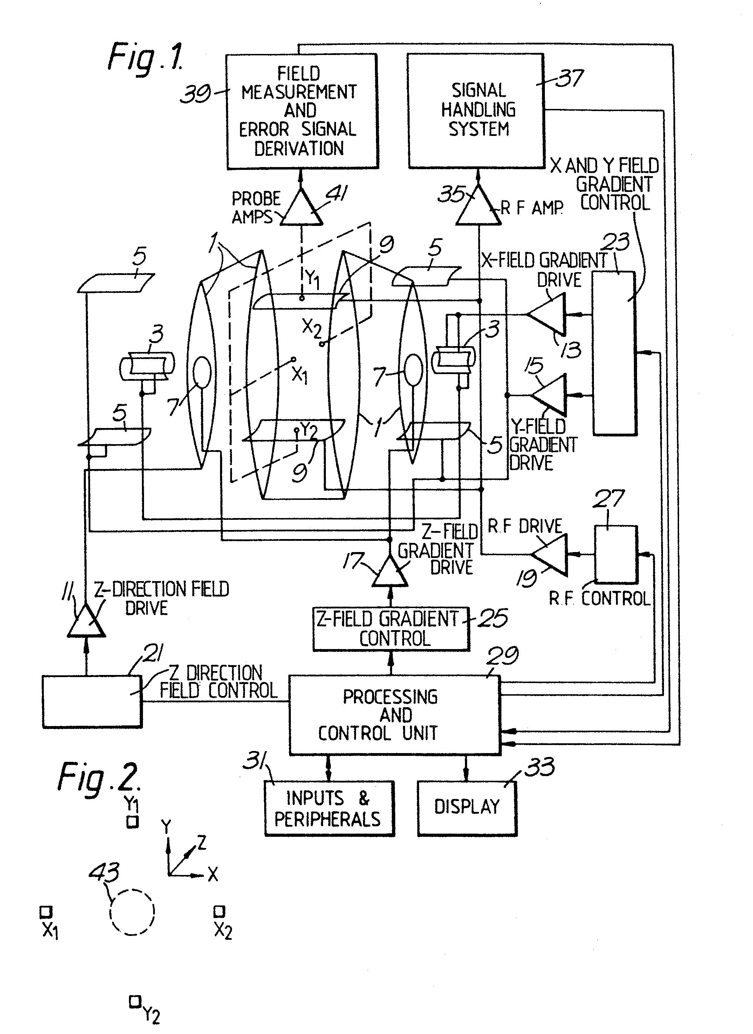

Referring to Figure 1, the first coil system comprises coils 1 capable of providing a steady uniform magnetic field in the Z direction; coils 3 capable of imposing a magnetic field gradient in the X direction, coils 5 capable of imposing a magnetic field gradient in the Y direction; and coils 7 capable of imposing a magnetic field gradient in the Z direction.

In addition, the apparatus includes a second coil system 9 whereby r.f. magnetic fields can be applied to the body under examination in a plane normal to the direction of the steady uniform magnetic field produced by the first coil system, and whereby r.f. magnetic fields resulting from nuclei in the body under examination which have been excited to nuclear magnetic resonance with a spin vector component other than in the Z direction can be detected.

In the drawing a single pair of coils 9 is shown for both applying and detecting r.f. fields, but in certain circumstances it may be preferable to provide separate coils for detecting the r.f. fields.

The various coils 1, 3, 5, 7 and 9 are driven by drive amplifiers 11, 12, 13, 15, 17 and 19 respectively, controlled by control circuits 21, 23, 25 and 27 respectively. These circuits may take various forms which are well known to those with experience of NMR equipment and other apparatus using coil induced magnetic fields.

The circuits 21, 23, 25 and 27 are controlled by a central processing and control unit 29 with which are associated inputs and other peripherals 31, for the provision of commands and instuctions to the apparatus, and a display 33.

The NMR signals detected by the coils 9 are applied via an amplifier 35 to a signal handling system 37. The signal handling system is arranged to make any appropriate calibration and correction of the signals, but essentially transmits the signals to the processing for application to the display to produce an image representing the distribution of an NMR quantity in the body being examined.

It will be appreciated that whilst shown separately to clarify the present description, the signal handling system 37 may conveniently form part of the unit 29.

The apparatus also includes field measurements and error signal circuits 39 which receive signals via amplifiers 41 from field probes $X_1$, $X_2$, $Y_1$ and $Y_2$ which are disposed at suitable positions in relation to the portion 43 of the body being examined as illustrated in Figure 2, to monitor the applied magnetic fields.

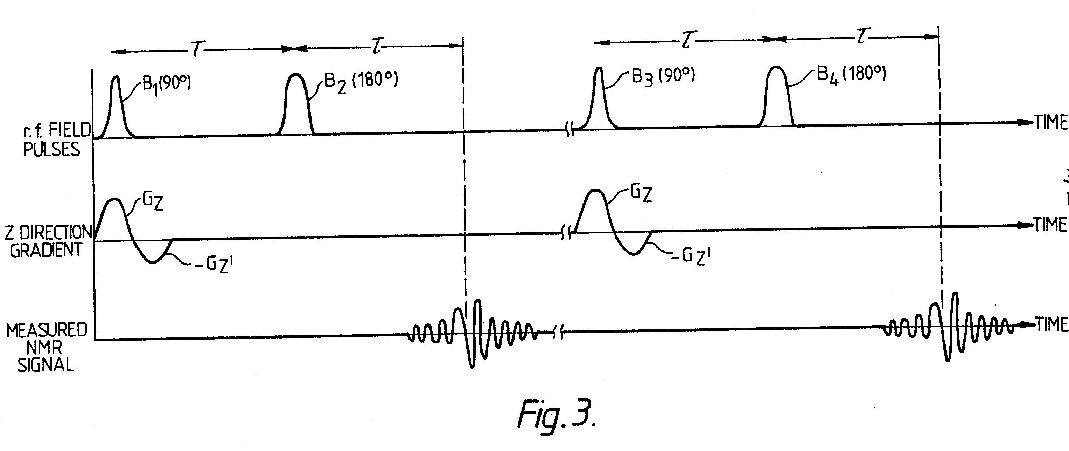

Referring now to Figure 3, in use of the apparatus a steady homogeneous magnetic field, Bo, is applied by the first coil system 1 to the body under examination in the Z direction. This field serves to define the equilibrium axis of magnetic alignment of the nuclei in the body i.e. along the Z direction, and remains constant throughout the examination procedure. An additional magnetic field Bz having a magnetic field gradient Gz along the Z direction is then applied by the coils 7 to the body, together with an r.f. magnetic field pulse denoted $B_1(90^{\circ})$, for reasons explained hereafter. The frequency of the r.f. field is chosen to be the Larmor frequency for hydrogen protons in a slice of the body, normal to the Z direction defined by a particular magnetic field along the Z direction, such that hydrogen protons within the slice are preferentially excited. The integral of the r.f. pulse is such that the pulse is just sufficient to tip the spins of the excited protons into the X-Y plane, and is thus referred to as a $90^\circ$ pulse, the spins then precessing in the X-Y plane round the Z axis.

The gradient Gz is then removed, and replaced by a gradient in the opposite sense -Gz'. This causes the rephasing of the spins which have been selectively excited by the combination of the RF pulse $B_1(90^\circ)$, Bo and the gradient Gz on the field Bz, the dephasing having been caused by the gradient through the slice. The magnitude of -Gz' is adjusted so that the spins are rephased at the time at which this gradient is switched off as described, for example, in the above mentioned U.K. Patent Specification No. 1,578,910.

A time period $\mathcal{L}$, measured from the time of application of the $B_1(90^\circ)$ is then allowed to elapse, and then a further r.f. magnetic field pulse $B_2$ $(180^\circ)$ is applied. The frequency of the r.f. field is chosen to be the Larmor frequency for hydrogen protons in the body in the magnetic field Bo, and the integral of the pulse is such that with a perfect coil system it is just sufficient to rotate the hydrogen proton spins through $180^\circ$, it therefore being referred to as a $180^\circ$ pulse. As the $B_2(180^\circ)$ pulse is applied in the absence of any magnetic gradient fields, hydrogen protons throughout the body are excited, the spins which were in the X-Y plane remaining in the X-Y plane, but rotated by $180^\circ$ within the plane whilst the spins which were lying along the equilibrium Z direction lie along the -Z direction. As however the second coil system 9 which applies the r.f. pulses is non-uniform, in particular having a fall off in sensitivity at the edges of the coils, then some of the spins will be rotated by angles which may considerably differ from 180°. Thus some of the spins which were aligned along the equilibrium Z direction,will have components of magnetisiation in the X-Y plane produced by the $B_2(180°)$ pulse. It will be appreciated that this first pulse sequence as so far described is the well known spin-echo sequence.

A further time period $\tau$ is allowed to elapse, and the echo signal produced after this time is measured by the coil system 9 in conventional manner. This signal will, of course, include an unwanted signal component originating from the spins outside the slice selected by the Gz gradient, which now have components of magnetisation in the X-Y plane. The present invention provides for the application of a further pulse sequence in order to compensate for this unwanted signal component, as described hereafter. A time period is allowed to elapse in order to allow all the spins to relax towards equilibrium alignment along the Z direction.

The first pulse sequence is then repeated in so much as a further r.f. magnetic field pulse $B_3(90°)$, having the same characteristics as the $B_1(90°)$ pulse is applied, together with the gradient Gz, the gradient Gz is then being removed and replaced for a time by the gradient -Gz' as before. A time period $\tau$ is allowed to elapse, and then an r.f. magnetic field pulse $B_4(180°)$ of the same r.f. frequency and having the same integral as the $B_2(180°)$ pulse, but 180° out of phase to it is applied. The $B_4(180°)$ pulse is then effective to rotate the hydrogen proton spins by 180° in the opposite sense to the $B_2(180°)$ pulse. Thus the components of magnetisation in the X-Y plane produced by the $B_4(180°)$ pulse from the spins which were aligned along the equilibrium Z axis, will be in the opposite direction within the X-Y plane with respect to the equivalent components produced by the $B_2(180°)$ pulse.

A further time period $\tau$ is allowed to elapse, and the echo signal produced after this time is measured by the coil system 9, this signal including a component produced by the $B_4(180^\circ)$ pulse originating from spins outside the slice selected by the Gz gradients. As this signal component will, however, be $180^\circ$ out of phase to the equivalent signal component produced in the first echo signal by the $B_2(180^\circ)$ pulse, by averaging the two measured echo signals in the signal handling system, a signal is produced in which the unwanted signal component is cancelled out. this averaged signal being then analysed in any desired manner to provide a signal representative of the quantity being investigated.

It will be appreciated that whilst the invention finds particular application in spin-echo sequences. it is equally applicable to other pulse sequences in which $180^\circ$ pulses are applied for example in inversion recovery sequences.

It will also be appreciated that whilst the method described herebefore relates to a magnetic field pulse sequence including one pair of $180^\circ$ pulses. each $180^\circ$ pulse within the pair being $180^\circ$ out of phase with the other, an NMR signal being measured after each sequence, the invention is equally applicable to sequences in which further pairs of $180^\circ$ pulses are applied, the pulses within each pair being $180^\circ$ out of phase with each other, and the measured signals are being averaged.

It will also be appreciated that whilst the method described herebefore relates to rotating the spins of hydrogen protons, the method is equally applicable to rotating the spins of other nuclei having a magnetic spin, e.g. $^{31}P$, by appropriate choice of the R.F. pulse frequency.

It is pointed out that although in the particular embodiment of the invention described above by way of example $180^\circ$ pulses without selection gradients are applied. the invention is also applicable where $180^\circ$ pulses with selection gradients are required e.g. in multi-slice sequences.

## CLAIMS

1.  A method of investigating the spatial distribution of a quantity relating to nuclear magnetic resonance in a body in which the spins of the chosen nucleus in the body are rotated through $180°$, and the nuclear magnetic resonance signal from said body measured after said rotation characterised in that: an even number of r.f. magnetic field pulses ($B_2$, $B_4$) are applied, each at the Larmor frequency for said nucleus and each intended to rotate the spins of said nuclei through substantially $180°$, half ($B_2$) of said number of pulses have a phase difference of substantially $180°$ with respect to the other half ($B_4$) of said number of pulses; nuclear magnetic resonance signals from said body after each of said pulses are measured; and said signals are averaged.

2.  A method according to Claim 1 in which each of said pulses ($B_2$, $B_4$) is applied in the presence of a gradient magnetic field.

3.  An apparatus for investigating the spatial distribution of a quantity relating to nuclear magnetic resonance in a body characterised in that it includes: means (9) arranged to apply an even number of r.f. magnetic field pulses ($B_2$, $B_4$) each at the Larmor frequency for a chosen nucleus in the body and each intended to rotate the spins of said nuclei through substantially $180°$, half of said number of pulses having a phase difference of substantially $180°$ with respect to the other half of said number of pulses, means (9) arranged to measure nuclear magnetic resonance signals from said body after each of said pulses; and means (37) arranged to average said signals.

4.  An apparatus according to Claim 3 including means (7) arranged to apply a gradient magnetic field during each of said pulses.

Fig.1.

0129356

1/2

Fig.2.

Fig.3.